# EUROPÄISCHE PATENTSCHRIFT

(11) **EP 3 341 963 B1**
(45) Veröffentlichungstag und Bekanntmachung des Hinweises auf die Patenterteilung: **03.03.2021**
(21) Anmeldenummer: 16731569.6
(22) Anmeldetag: 21.06.2016
(51) Int. Cl.: H01L 23/36, H01L 25/07, H01L 23/433, H01L 23/40

(54) **VORRICHTUNG ZUR KÜHLUNG VON ELEKTRISCHEN BAUELEMENTEN**
DEVICE FOR COOLING ELECTRICAL COMPONENTS
DISPOSITIF DE REFROIDISSEMENT DE COMPOSANTS ÉLECTRIQUES

(30) Priorität: 24.08.2015 DE 102015216102
(43) Veröffentlichungstag der Anmeldung: 04.07.2018
(73) Patentinhaber: Robert Bosch GmbH, 70442 Stuttgart (DE)
(72) Erfinder: TAUFER, Peter, 71272 Renningen (DE); BUTZMANN, Stefan, 58579 Schalksmühle (DE); ECKERT, Bernd, 71665 Vaihingen an der Enz (DE)
(86) Internationale Anmeldenummer: PCT/EP2016/064257
(87) Internationale Veröffentlichungsnummer: WO 2017/032477

(56) Entgegenhaltungen:
- WO-A1-2014/132399
- DE-A1-102012 206 407
- US-A- 4 884 167
- US-A1- 2002 159 237
- US-A1- 2005 040 515
- US-E- R E35 721

## Beschreibung

Die Erfindung betrifft eine Vorrichtung zur Kühlung einer Vielzahl von elektrischen Bauelementen. Ferner betrifft die Erfindung ein Leistungsmodul zur Ansteuerung eines elektrischen Antriebes, sowie einen Wechselrichter mit einem Leistungsmodul.

### Stand der Technik

Zum Betreiben elektrischer Antriebe werden üblicherweise Wechselrichter eingesetzt, die elektrische Energie aus einer Gleichspannungsquelle, z. B. einer Batterie, in eine Wechselspannung bzw. in einen Wechselstrom umwandeln. Mit der Wechselspannung wird eine elektrische Maschine, beispielsweise eine Synchron- oder Asynchronmaschine, versorgt. Ein Wechselrichter umfasst dabei Leistungsmodule, die Schaltelemente oder Leistungshalbleiterschalter umfassen. Mittels einer pulsweitenmodulierten Ansteuerung der Schaltelemente, wird die anliegende Gleichspannung in eine Wechselspannung gewandelt. Beim Betrieb des Wechselrichters werden diese Schaltelemente heiß. Zur Vermeidung der Überhitzung und zur Verlängerung der Lebensdauer der Schaltelemente werden diese, beziehungsweise auch die Leistungsmodule, gekühlt.

Aus der DE 10 2011 088 218 A1 ist ein elektronisches Leistungsmodul bekannt, welches ein Entwärmungselement umfasst, zur Entwärmung der Schaltelemente des Leistungsmoduls beziehungsweise zur Entwärmung der Halbleiterchips oder Leistungshalbleiterschalter.

Aus der US 4884167 ist ein elektronisches Leistungsmodul bekannt, welches eine Vielzahl an Entwärmungselementen zur Entwärmung der Schaltelemente des Leistungsmoduls umfasst.

Aus der US 2005/0040515 A1 ist ein elektronisches Leistungsmodul bekannt, welches zwei Entwärmungselemente zur Entwärmung der dazwischenliegenden Schaltelemente des Leistungsmoduls umfasst.

Aus der US 2002/0159237 A1 ist ein elektronisches Leistungsmodul bekannt, welches eine Vielzahl an Entwärmungselementen zur Entwärmung der Schaltelemente des Leistungsmoduls umfasst.

Aus der WO 2014/132399 A1 ist eine Kühlerstruktur für elektronische Bauelemente mit Wärmeübertragern bekannt, welche die Wärme der elektronischen Bauelemente auf ein Gehäuse übertragen.

Aus der DE 10 2012 206407 A1 ist eine Druckkontaktanordnung zur elektrischen Kontaktierung großflächiger Halbleiterchips bekannt.

Es besteht das Bedürfnis derartige Kühlvorrichtungen und Leistungsmodule zu verkleinern und deren Packungsdichte und Leistungsdichte zu erhöhen.

### Offenbarung der Erfindung

Es wird eine Vorrichtung zur Kühlung einer Vielzahl von elektrischen Bauelementen nach Anspruch 1 bereitgestellt.
Es wird eine Vorrichtung zur Kühlung einer Vielzahl von elektrischen Bauelementen bereitgestellt. Bei den elektrischen Bauelementen handelt es sich insbesondere um Schaltelemente, die beispielsweise zur Wandlung einer Gleichspannung in eine Wechselspannung verwendet werden, also insbesondere Leistungshalbleiterschalter. Diese elektrischen Bauelemente, die insbesondere als Halbleiterchips aus Siliziumwafern gefertigt sind, weisen eine ebene Oberfläche auf, die als Kontaktfläche zur Entwärmung geeignet ist. Im Rahmen dieser Erfindung umfasst der Begriff Bauelementkühlfläche auch diese ebene Oberfläche des Halbleiterchips. Der Begriff umfasst aber auch eine gegebenenfalls zusätzlich auf den Halbleiterchip aufgebrachte Schicht. Die erfindungsgemäße Vorrichtung weist einen ersten und einen zweiten Kühlkörper auf, die jeweils wiederum Kühlkörperkühlflächen aufweisen, die gegenüberliegend flächig angeordnet sind. Die Kühlkörperkühlflächen sind derart gestaltet, dass jeweils eine Anbringung einer Teilmenge der Bauelementkühlflächen der elektrischen Bauelemente ermöglicht wird. Insbesondere können der erste Kühlkörper und der zweite Kühlkörper Teilkörper eines einstückigen Kühlkörpers sein, wie auch insbesondere die Kühlkörperkühlflächen Teilflächen eines einstückigen Kühlkörpers sein können. Weiter sind Befestigungsmittel vorgesehen, insbesondere mechanische, die ein Befestigen der Bauelementkühlflächen an den Kühlkörperkühlflächen ermöglichen. Hierbei sind die Befestigungsmittel derart gestaltet, dass eine Wärmeübertragung aus den Bauelementen in die Kühlkörper sichergestellt wird, indem insbesondere die Bauelementkühlflächen an die Kühlkörperkühlflächen angepresst werden.

Vorteilhaft wird somit eine Vorrichtung zur Kühlung einer Vielzahl von elektrischen Bauelementen bereitgestellt, die eine hohe Packungsdichte ermöglicht, aufgrund der Möglichkeit, die Vielzahl der elektrischen Bauelemente an den gegenüberliegenden Kühlkörperkühlflächen anzubringen.

Erfindungsgemäß ist vorgesehen, dass die Kühlkörperkühlflächen zur Anbringung eines Teils der Bauelementkühlflächen der Vielzahl von elektrischen Bauelementen derart ausgestaltet sind, dass entlang einer Geraden in einer Ebene elektrische Bauelemente nebeneinander positioniert anbringbar sind, wobei eine Bauelementkühlfläche eines ersten elektrischen Bauelementes an die erste Kühlkörperkühlfläche und abwechselnd eine Bauelementkühlfläche eines weiteren elektrischen Bauelementes an die zweite Kühlkörperkühlfläche angebracht sind. Eine derartige abwechselnde Anbringung der elektrischen Bauelemente an der oberen und der unteren Kühlkörperkühlfläche bewirkt, dass Teilbereiche auf der Kühlkörperkühlfläche verbleiben, an denen kein elektrisches Bauelement angebracht wird. Vorteilhaft ergibt sich somit vergleichsweise höhere Entwärmungskapazität des Kühlkörpers.

In einer anderen Ausgestaltung der Erfindung ist vorgesehen, dass eine Kühlkörperkühlfläche als eine zumindest teilweise plane Oberfläche ausgebildet ist.

So kann ein möglichst großflächiger Kontakt zwischen den Bauelementkühlflächen und der Kühlkörperkühlfläche hergestellt werden. Vorteilhaft wird somit die Wärmeübertragung zwischen dem Bauelement und dem Kühlkörper optimiert.

In einer anderen Ausgestaltung der Erfindung ist vorgesehen, dass die erste und die zweite Kühlkörperkühlfläche zur Anbringung einer Teilmenge der Bauelementkühlflächen der Vielzahl von elektrischen Bauelementen derart ausgestaltet sind, dass an jede der ersten und zweiten Kühlkörperkühlflächen etwa eine Hälfte der anzubringenden Vielzahl von elektrischen Bauelementen anbringbar ist.

Jeweils etwa die Hälfte der Vielzahl der benötigten elektrischen Bauelemente kann somit an der ersten und der zweiten Kühlkörperkühlfläche angebracht werden. Die Kühlkörperkühlflächen sind gegenüberliegend flächig angeordnet. Vorteilhaft halbiert sich somit in etwa der Flächenbedarf, der vergleichsweise bei einer einseitigen, beziehungsweise einschichtigen, Kühlung der Bauelemente notwendig gewesen wäre.

In einer anderen Ausgestaltung der Erfindung sind die Befestigungsmittel in Form eines federnden Elementes ausgestaltet.

Ein federndes Element kann beispielsweise metallisch oder aus Kunststoff sein. Aber auch federnde Elemente aus anderen Werkstoffen, wie beispielsweise Faserverbundwerkstoffe, Glasfaser oder Kohlefaser oder keramische Verbindungen sind einsetzbar. Die Form kann beispielsweise spiralförmig, c-förmig oder klammerförmig gestaltet sein. Die Verwendung eines federnden Elementes als Befestigungsmittel bewirkt ein Anpressen der elektrischen Bauelemente an den Kühlkörper. Mittels dieser Pressung wird die Wärmeübertragung von dem Bauelement auf den Kühlkörper optimiert. Darüber hinaus kann das federnde Element temperaturbedingte Verspannungen und Ablösungen der innerhalb dieser Vorrichtung verwendeten Materialien zueinander ausgleichen und kompensieren.

In einer anderen Ausgestaltung der Erfindung ist ein Befestigungsmittel derart ausgestaltet, dass es in Form eines federnden Elementes an einer der Bauelementkühlfläche gegenüberliegenden ersten Bauelementfläche eines elektronischen Bauelementes einerseits abstützbar ist, und andererseits an einer der ersten Bauelementfläche gegenüberliegenden Kühlkörperkühlfläche, an einer der ersten Bauelementfläche gegenüberliegenden zweiten Bauelementfläche eines weiteren elektrischen Bauelementes, oder an einem der ersten Bauelementfläche gegenüberliegenden mechanischen Fixpunkt abstützbar ist. Es wird ein Befestigungsmittel bereitgestellt, welches in Form eines federnden Elementes, insbesondere in Form einer Feder, ausgestaltet ist. Dieses Befestigungsmittel wird an einer der Bauelementkühlfläche gegenüberliegenden ersten Bauelementfläche eines elektronischen Bauelementes abgestützt, wobei insbesondere die Federkraft weitestgehend orthogonal auf die Bauelementkühlfläche gerichtet ist. Die in Richtung der Federkraft gegenüberliegende Seite des Befestigungsmittels wird entweder an einer der ersten Bauelementfläche gegenüberliegenden Kühlkörperkühlfläche abgestützt oder an einer der ersten Bauelementfläche gegenüberliegenden zweiten Bauelementfläche eines weiteren elektrischen Bauelementes abgestützt. In dem zweiten Fall sind somit zwei elektronische Bauelemente mindestens teilweise übereinanderliegend angeordnet. Weiter kann das Befestigungsmittel mit dem in Richtung der Federkraft gegenüberliegenden anderen Ende an einem der ersten Bauelementfläche gegenüberliegenden mechanischen Fixpunkt abgestützt sein. Dieser Fixpunkt kann ein passives oder aktives Element sein, insbesondere ein elektronisches Bauelement. Dieser Fixpunkt kann aus unterschiedlichen geeigneten Materialien bestehen, wie beispielsweise Metall, Faserverbundwerkstoff, Glasfaser oder Kohlefaser oder aus keramischen Verbindungen.

Vorteilhaft werden Varianten vorgestellt, wie das Befestigungsmittel abgestützt werden kann, um ein Anpressen des Bauelementes an den Kühlkörper zu gewährleisten.

In einer anderen Ausgestaltung der Erfindung ist vorgesehen, dass ein Befestigungsmittel derart ausgestaltet ist, dass es die Bauelementkühlfläche des elektronischen Bauelementes und die Kühlkörperkühlfläche aneinander klemmt beziehungsweise aneinander zieht.
Es wird ein Befestigungsmittel bereitgestellt, welches beispielsweise bogenförmig über ein Bauelement gespannt wird, und beiderseits des Bauelementes an dem Kühlkörper fixiert wird. Vorteilhaft wird somit ein Befestigungsmittel bereitgestellt, welches keine mechanische Abstützung auf einer der Kühlkörperkühlfläche gegenüberliegenden Fläche benötigt.

In einer weiteren Ausgestaltung der Erfindung ist vorgesehen, dass ein Befestigungsmittel eine Schraube oder einen Niet umfasst. Die Fixierung des Bauelementes an dem Kühlkörper kann beispielsweise mittels einer Schraube oder eines Niets erfolgen. Auch die Fixierung eines Befestigungsmittels an einen Kühlkörper oder der Kühlkörperkühlfläche kann beispielsweise mittels einer Schraube oder eines Niets erfolgen. Vorteilhaft werden Varianten bereitgestellt, die eine sichere Fixierung des Befestigungsmittels gewährleisten.

In einem Beispiel, das keine Ausgestaltung der Erfindung ist, ist vorgesehen, dass die Kühlkörperkühlflächen zur Anbringung einer Teilmenge der Bauelementkühlflächen der Vielzahl von elektrischen Bauelementen derart ausgestaltet sind, dass ein erstes und ein zweites elektrisches Bauelement in zwei Ebenen übereinander anbringbar sind, wobei eine Bauelementkühlfläche des ersten elektrischen Bauelementes an die Kühlkörperkühlfläche des ersten Kühlkörpers, und eine Bauelementkühlfläche eines zweiten elektrischen Bauelementes an die Kühlkörperkühlfläche des zweiten Kühlkörpers anbringbar ist.

Dies bedeutet, dass die Bauelemente übereinanderliegend angeordnet sind. Eines der Bauelemente wird in Richtung des ersten Kühlkörpers entwärmt, und ein zweites Bauelement wird in Richtung des zweiten Kühlkörpers entwärmt. Durch diese Anordnung der Bauelemente und der Kühlkörper zueinander, wird eine besonders hohe Packungsdichte der Bauelemente realisiert.

Ferner wird ein Leistungsmodul bereitgestellt zur Ansteuerung eines elektrischen Antriebes. Das Leistungsmodul weist eine, wie oben beschriebene Vorrichtung zur Kühlung der angebrachten Vielzahl der elektrischen Bauelemente, insbesondere Schaltelemente und/oder Leistungshalbleiterschalter, auf. Es wird ein Leistungsmodul bereitgestellt, welches neben der Vielzahl elektrischer Bauelemente eine wie bisher beschriebene Vorrichtung zur Kühlung der elektrischen Bauelemente aufweist. Vorteilhaft wird ein Leistungsmodul mit einer hohen Packungsdichte und Leistungsdichte bereitgestellt.

Ferner wird ein Wechselrichter bereitgestellt, welcher ein wie oben beschriebenes Leistungsmodul umfasst. Vorteilhaft wird ein Wechselrichter mit einer hohen Packungsdichte und Leistungsdichte bereitgestellt.

Es versteht sich, dass die Merkmale, Eigenschaften und Vorteile der erfindungsgemäßen Vorrichtung entsprechend auf das Leistungsmodul bzw. den Wechselrichter und umgekehrt zutreffen, bzw. anwendbar sind.

Weitere Merkmale und Vorteile von Ausführungsformen der Erfindungen ergeben sich aus der nachfolgenden Beschreibung mit Bezug auf die beigefügten Zeichnungen.

### Kurze Beschreibung der Zeichnung

Im Folgenden soll die Erfindung anhand einiger Figuren näher erläutert werden, dazu zeigen
Figur 1
   schematisch ein Ausführungsbeispiel einer Vorrichtung zur Kühlung einer Vielzahl von elektrischen Bauelementen in einer schematischen Darstellung,
Figur 2
   ebenfalls schematisch ein Beispiel einer Vorrichtung zur Kühlung einer Vielzahl von elektrischen Bauelementen das keine Ausgestaltung der Erfindung ist.
Figur 3
   ein an einen Kühlkörper fixiertes Befestigungsmittel,
Figur 4
   einen Wechselrichter mit einem Leistungsmodul zur Versorgung einer elektrischen Maschine.

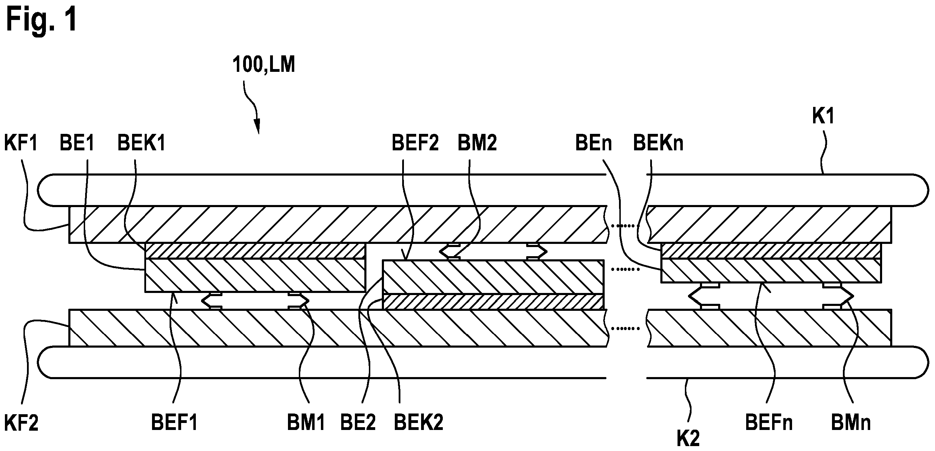

Die Figur 1 zeigt schematisch eine Ausführungsform der Erfindung mit einer Vorrichtung 100 bzw. einem Ausschnitt aus einem Leistungsmodul, umfassend einen ersten Kühlkörper K1 mit einer ersten Kühlkörperkühlfläche KF1, sowie einen zweiten Kühlkörper K2 mit einer der ersten Kühlkörperkühlfläche KF1 flächig beabstandet gegenüberliegend angeordneten zweiten Kühlkörperkühlfläche KF2. Weiter ist eine Vielzahl von elektrischen Bauelementen BE1, BE2 .. BEn beispielhaft dargestellt. Die einzelnen Bauelemente umfassen jeweils eine Bauelementkühlfläche BEK1, BEK2 .. BEKn. Weiter sind Befestigungsmittel BM1, BM2 .. BMn dargestellt, die sich an den der Bauelementkühlflächen BEK1, BEK2 .. BEKn gegenüber angerordneten Bauelementflächen BEF1, BEF2 .. BEFn der Vielzahl der elektrischen Bauelemente einerseits und an der gegenüberliegenden Kühlkörperkühlfläche KF1, KF2 andererseits abstützen.

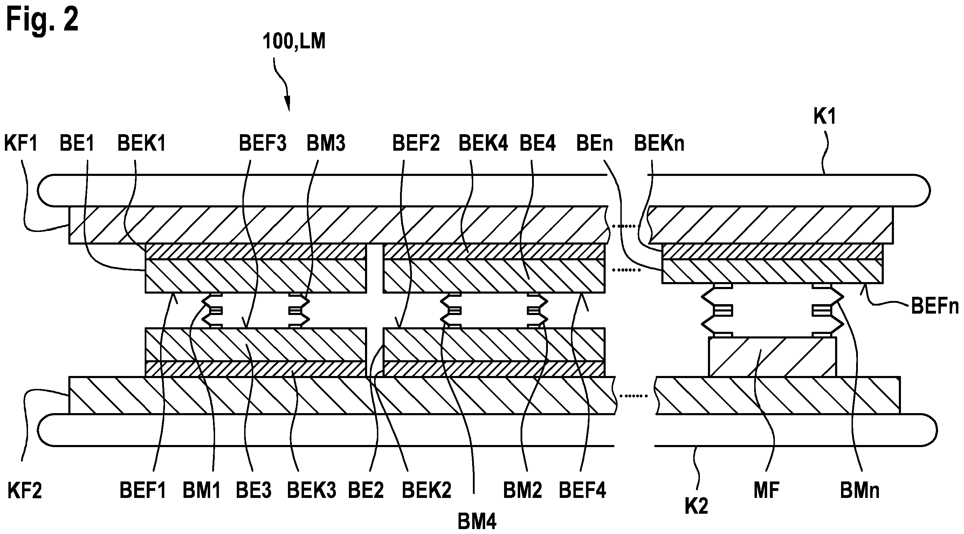

Figur 2 zeigt schematisch ein Beispiel, das keine Ausführungsform der Erfindung darstellt, mit einem ähnlichen Aufbau der Kühlkörper K1, K2 und der dazugehörigen Kühlkörperkühlflächen KF1 und KF2, sowie gegenüberliegend angeordneten Bauelementen BE1, BE3 beziehungsweise BE4, BE2. Die dargestellten Befestigungsmittel BM1, BM2, BM3, BM4 stützen sich an der der Bauelementkühlfläche BEK1, BEK2, BEK3, BEK4 gegenüberliegenden ersten Bauelementfläche BEF1, BEF2, BEF3, BEF4 der elektronischen Bauelemente BE1, BE2, BE3, BE4 einerseits ab, und andererseits an der der ersten Bauelementfläche BEF1, BEF2, BEF3, BEF4 gegenüberliegenden zweiten Bauelementfläche, BEF1, BEF2, BEF3, BEF4 eines weiteren elektrischen Bauelementes ab. Weiter ist ein Befestigungsmittel BMn dargestellt, welches sich einerseits an einer der Bauelementkühlfläche BEKn gegenüberliegenden ersten Bauelementfläche BEFn des elektronischen Bauelementes BEn einerseits abstützt und an einem der ersten Bauelementfläche BEFn gegenüberliegenden mechanischen Fixpunkt MF abstützt. Sich gegenüberliegende Befestigungsmittel, wie beispielsweise BM1 und BM3, können sich auch gegeneinander zwischen den Bauelementen abstützen. Alternativ können zwei sich gegenüberliegende Befestigungsmittel, wie beispielsweise BM2 und BM4 auch einstückig als gemeinsames Befestigungsmittel ausgebildet sein.

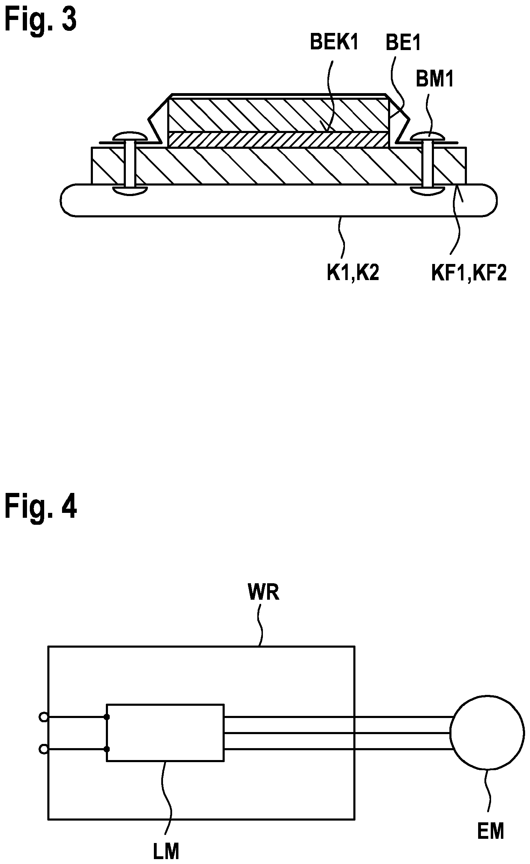

Figur 3 zeigt einen Kühlkörper K1, K2 mit einer Kühlkörperkühlfläche KF1, KF2 und einem daran angebrachten Bauelement BE1 mit einer Bauelementkühlfläche BEK1, wobei ein Befestigungsmittel BM1 in Form einer federnden Klammer um das Bauelement BE1 dargestellt ist, welches mittels einer Schraube oder eines Niets an dem Kühlkörper K1, K2 fixiert ist.

Figur 4 zeigt in einer schematischen Darstellung einen Wechselrichter WR der mindestens ein Leistungsmodul LM umfasst, welches zur Ansteuerung einer elektrischen Maschine EM dient.

## Patentansprüche

1. Vorrichtung (100) mit einer Vielzahl von elektrischen Bauelementen (BE1, BE2 .. BEn) zur Kühlung der Vielzahl von elektrischen Bauelementen (BE1, BE2 .. BEn), wobei die elektrischen Bauelemente (BE1, BE2 .. BEn) jeweils eine zu kühlende Bauelementkühlfläche (BEK1, BEK2 .. BEKn) aufweisen, wobei die Vorrichtung (100) einen ersten Kühlkörper (K1) mit einer ersten Kühlkörperkühlfläche (KF1) und einen zweiten Kühlkörper (K2) mit einer zweiten Kühlkörperkühlfläche (KF2) aufweist, wobei die Kühlkörperkühlflächen (KF1, KF2) gegenüberliegend flächig angeordnet sind, und die erste Kühlkörperkühlfläche (KF1) zur Anbringung einer ersten Teilmenge der Bauelementkühlflächen (BEK1, BEK2 .. BEKn) der Vielzahl von elektrischen Bauelementen (BE1, BE2 .. BEn) ausgestaltet ist und die zweite Kühlkörperkühlfläche (KF2) zur Anbringung einer zweiten Teilmenge der Bauelementkühlflächen (BEK1, BEK2 .. BEKn) der Vielzahl von elektrischen Bauelementen (BE1, BE2 .. BEn) ausgestaltet ist und Befestigungsmittel (BM1, BM2 .. BMn) vorgesehen sind zur Befestigung der anzubringenden Bauelementkühlflächen (BEK1, BEK2 .. BEKn) der Vielzahl von elektrischen Bauelementen (BE1, BE2 .. BEn) an die Kühlkörperkühlflächen (KF1, KF2), wobei die Kühlkörperkühlflächen (KF1, KF2) zur Anbringung eines Teils der Bauelementkühlflächen (BEK1, BEK2 .. BEKn) der Vielzahl von elektrischen Bauelementen (BE1, BE2 .. BEn) derart ausgestaltet sind, dass entlang einer Geraden in einer Ebene elektrische Bauelemente (BE1, BE2 .. BEn) nebeneinander positioniert angebracht sind,
**dadurch gekennzeichnet, dass**
eine Bauelementkühlfläche (BEK1, BEK2 .. BEKn) eines ersten elektrischen Bauelementes (BE1, BE2 .. BEn) an die erste Kühlkörperkühlfläche (KF1) und eine Bauelementkühlfläche (BEK1, BEK2 .. BEKn) eines weiteren elektrischen Bauelementes abwechselnd an die zweite Kühlkörperkühlfläche (KF2) angebracht sind.

2. Vorrichtung (100) nach Anspruch 1, **dadurch gekennzeichnet, dass** eine Kühlkörperkühlfläche (KF1, KF2) als eine zumindest teilweise plane Oberfläche ausgebildet ist.

3. Vorrichtung (100) nach einem der vorhergehenden Ansprüche, **dadurch gekennzeichnet, dass**
die erste und zweite Kühlkörperkühlflächen (KF1, KF2) zur Anbringung einer Teilmenge der Bauelementkühlflächen (BEK1, BEK2 .. BEKn) der Vielzahl von elektrischen Bauelementen (BE1, BE2 .. BEn) derart ausgestaltet sind, dass an jede der ersten und zweiten Kühlkörperkühlflächen (KF1, KF2) etwa eine Hälfte der anzubringenden Vielzahl von elektrischen Bauelementen (BE1, BE2 .. BEn) anbringbar ist.

4. Vorrichtung (100) nach einem der vorhergehenden Ansprüche, **dadurch gekennzeichnet, dass**
ein Befestigungsmittel (BM1, BM2 .. BMn) in Form eines federnden Elementes ausgestaltet ist.

5. Vorrichtung (100) nach einem der vorhergehenden Ansprüche, **dadurch gekennzeichnet, dass**
ein Befestigungsmittel (BM1, BM2 .. BMn) derart ausgestaltet ist, dass es in Form eines federnden Elementes an einer der Bauelementkühlfläche (BEK1, BEK2 .. BEKn) gegenüberliegenden ersten Bauelementfläche (BEF1, BEF2 .. BEFn) eines elektronischen Bauelementes (BE1, BE2 .. BEn) einerseits abstützbar ist und andererseits
an einer der ersten Bauelementfläche (BEF1, BEF2 .. BEFn) gegenüberliegenden Kühlkörperkühlfläche (KF1, KF2),
an einer der ersten Bauelementfläche (BEF1, BEF2 .. BEFn) gegenüberliegenden zweiten Bauelementfläche (BEF1, BEF2 .. BEFn) eines weiteren elektrischen Bauelementes,
oder an einem der ersten Bauelementfläche (BEF1, BEF2 .. BEFn) gegenüberliegenden mechanischen Fixpunkt (MF) abstützbar ist.

6. Vorrichtung (100) nach einem der Ansprüche 1 bis 4, **dadurch gekennzeichnet, dass**
ein Befestigungsmittel (BM1, BM2 .. BMn) derart ausgestaltet ist, dass es die Bauelementkühlfläche (BEK1, BEK2 .. BEKn) des elektronischen Bauelementes (BE1, BE2 .. BEn) und die Kühlkörperkühlfläche (KF1, KF2) aneinander klemmt.

7. Vorrichtung (100) nach einem der Ansprüche 1 bis 3, **dadurch gekennzeichnet, dass**
ein Befestigungsmittel (BM1, BM2 .. BMn) eine Schraube oder einen Niet umfasst.

8. Leistungsmodul (LM) zur Ansteuerung eines elektrischen Antriebes (EM) mit einer Vorrichtung (100) nach den vorhergehenden Ansprüchen zur Kühlung der angebrachten Vielzahl der elektrischen Bauelemente (BE1, BE2 .. BEn), insbesondere Schaltelemente (SE) und/oder Leistungshalbleiterschalter.

9. Wechselrichter (WR) mit einem Leistungsmodul (LM) nach Anspruch 8.

## Claims

1. Device (100) having a multiplicity of electrical components (BE1, BE2..BEn) for cooling the multiplicity of electrical components (BE1, BE2..BEn), wherein the electrical components (BE1, BE2..BEn) comprise in each case a component cooling surface (BEK1, BEK2..BEKn) to be cooled, wherein the device (100) comprises a first cooling body (K1) having a first cooling body cooling surface (KF1) and a second cooling body (K2) having a second cooling body cooling surface (KF2), wherein the cooling body cooling surfaces (KF1, KF2) are arranged opposite one another in a planar manner, and the first cooling body cooling surface (KF1) is configured for attaching a first part quantity of the component cooling surfaces (BEK1, BEK2..BEKn) of the multiplicity of electrical components (BE1, BE2..BEn) and
the second cooling body cooling surface (KF2) is configured for attaching a second part quantity of the component cooling surfaces (BEK1, BEK2..BEKn) of the multiplicity of electrical components (BE1, BE2.. BEn)
and fastening means (BM1, BM2..BMn) are provided for fastening the component cooling surfaces (BEK1, BEK2..BEKn), which are to be attached, of the multiplicity of electrical components (BE1, BE2..BEn) to the cooling body cooling surfaces (KF1, KF2),
wherein the cooling body cooling surfaces (KF1, KF2) are configured for attaching a part of the component cooling surfaces (BEK1, BEK2..BEKn) of the multiplicity of electrical components (BE1, BE2..BEn) in such a manner that electrical components (BE1, BE2..BEn) are attached positioned adjacent to one another along a straight line in one plane,
**characterized in that**
a component cooling surface (BEK1, BEK2..BEKn) of a first electrical component (BE1, BE2..BEn) is attached to the first cooling body cooling surface (KF1) and a component cooling surface (BEK1, BEK2..BEKn) of a further electrical component is attached alternately to the second cooling body cooling surface (KF2).

2. Device (100) according to Claim 1, **characterized in that** a cooling body cooling surface (KF1, KF2) is configured as an at least in part planar surface.

3. Device (100) according to either of the preceding claims, **characterized in that**
the first and second cooling body cooling surfaces (KF1, KF2) are configured for attaching a part quantity of component cooling surfaces (BEK1, BEK2..BEKn) of the multiplicity of electrical components (BE1, BE2..BEn) in such a manner that it is possible to attach to each of the first and second cooling body cooling surfaces (KF1, KF2) approximately half of the multiplicity of electrical components (BE1, BE2..BEn) that are to be attached.

4. Device (100) according to any one of the preceding claims, **characterized in that**
a fastening means (BM1, BM2..BMn) is configured in the form of a resilient element.

5. Device (100) according to any one of the preceding claims, **characterized in that**
a fastening means (BM1, BM2..BMn) is configured in such a manner that in the form of a resilient element it can be supported on the one hand on a first component surface (BEF1, BEF2..BEFn) of an electronic component (BE1, BE2..BEn), said first component surface lying opposite the component cooling surface (BEK1, BEK2..BEKn) and on the other hand it can be supported
on a cooling body cooling surface (KF1, KF2) that lies opposite the first component surface (BEF1, BEF2.. BEFn),
on a second component surface (BEF1, BEF2..BEFn) of a further electrical component, said second component surface lying opposite the first component surface (BEF1, BEF2..BEFn),
or on a mechanical fixing point (MF) that lies opposite the first component surface (BEF1, BEF2. .BEFn).

6. Device (100) according to any one of Claims 1 to 4, **characterized in that**
a fastening means (BM1, BM2..BMn) is configured in such a manner that it clamps the component cooling surface (BEK1, BEK2..BEKn) of the electronic component (BE1, BE2..BEn) and the cooling body cooling surface (KF1, KF2) against one another.

7. Device (100) according to any one of Claims 1 to 3, **characterized in that**
a fastening means (BM1, BM2..BMn) comprises a screw or a rivet.

8. Power module (LM) for controlling an electric drive (EM) having a device (100) according to the preceding claims for cooling the attached multiplicity of electrical components (BE1, BE2..BEn), in particular switching elements (SE) and/or semiconductor power switches.

9. Inverter (WR) having a power module (LM) according to Claim 8.

## Revendications

1. Dispositif (100), comprenant une pluralité de composants électriques (BE1, BE2 ... BEn) pour refroidir la pluralité de composants électriques (BE1, BE2 ... BEn), les composants électriques (BE1, BE2 ... BEn) présentant respectivement une surface de refroidissement de composant (BEK1, BEK2 ... BEKn) à refroidir, le dispositif (100) présentant un premier dissipateur thermique (K1) doté d'une première surface de refroidissement de dissipateur thermique (KF1) et un deuxième dissipateur thermique (K2) doté d'une deuxième surface de refroidissement de dissipateur thermique (KF2), les surfaces de refroidissement de dissipateur thermique (KF1, KF2) étant disposées à l'opposé en surface, et la première surface de refroidissement de dissipateur thermique (KF1) étant configurée pour l'installation d'un premier sous-ensemble des surfaces de refroidissement de composant (BEK1, BEK2 ... BEKn) de la pluralité de composants électriques (BE1, BE2 ... BEn), et la deuxième surface de refroidissement de dissipateur thermique (KF2) étant configurée pour l'installation d'un deuxième sous-ensemble des surfaces de refroidissement de composant (BEK1, BEK2 ... BEKn) de la pluralité de composants électriques (BE1, BE2 ... BEn), et des moyens de fixation (BM1, BM2 ... BMn) étant prévus pour fixer les surfaces de refroidissement de composant (BEK1, BEK2 ... BEKn) à installer de la pluralité de composants électriques (BE1, BE2 ... BEn) aux surfaces de refroidissement de dissipateur thermique (KF1, KF2),
les surfaces de refroidissement de dissipateur thermique (KF1, KF2) étant configurées pour l'installation d'une partie des surfaces de refroidissement de composant (BEK1, BEK2 ... BEKn) de la pluralité de composants électriques (BE1, BE2 ... BEn) de telle sorte que des composants électriques (BE1, BE2 ... BEn) sont installés le long d'une droite dans un plan en étant positionnés côte à côte,
**caractérisé en ce qu'**une surface de refroidissement de composant (BEK1, BEK2 ... BEKn) d'un premier composant électrique (BE1, BE2 ... BEn) est installée sur la première surface de refroidissement de dissipateur thermique (KF1) en alternance avec une surface de refroidissement de composant (BEK1, BEK2 ... BEKn) d'un autre composant électrique installée sur la deuxième surface de refroidissement de dissipateur thermique (KF2) .

2. Dispositif (100) selon la revendication 1, **caractérisé en ce qu'**une surface de refroidissement de dissipateur thermique (KF1, KF2) est réalisée comme une surface au moins partiellement plane.

3. Dispositif (100) selon l'une quelconque des revendications précédentes, **caractérisé en ce que** la première et la deuxième surface de refroidissement de dissipateur thermique (KF1, KF2) sont configurées pour l'installation d'un sous-ensemble des surfaces de refroidissement de composant (BEK1, BEK2 ... BEKn) de la pluralité de composants électriques (BE1, BE2 ... BEn) de telle sorte qu'environ la moitié de la pluralité de composants électriques (BE1, BE2 ... BEn) à installer peut être installée sur chacune de la première et de la deuxième surface de refroidissement de dissipateur thermique (KF1, KF2).

4. Dispositif (100) selon l'une quelconque des revendications précédentes, **caractérisé en ce qu'**un moyen de fixation (BM1, BM2 ... BMn) est configuré sous la forme d'un élément élastique.

5. Dispositif (100) selon l'une quelconque des revendications précédentes, **caractérisé en ce qu'**un moyen de fixation (BM1, BM2 ... BMn) est configuré de telle sorte que sous la forme d'un élément élastique, il peut d'une part prendre appui sur une première surface de composant (BEF1, BEF2 ... BEFn), opposée à la surface de refroidissement de composant (BEK1, BEK2 ... BEKn), d'un composant électronique (BE1, BE2 ... BEn), et peut d'autre part prendre appui sur une surface de refroidissement de dissipateur thermique (KF1, KF2) opposée à la première surface de composant (BEF1, BEF2 ... BEFn), sur une deuxième surface de composant (BEF1, BEF2 ... BEFn) opposée à la première surface de composant (BEF1, BEF2 ... BEFn) d'un autre composant électrique, ou sur un point fixe mécanique (MF) opposé à la première surface de composant (BEF1, BEF2 ... BEFn) .

6. Dispositif (100) selon l'une quelconque des revendications 1 à 4, **caractérisé en ce qu'**un moyen de fixation (BM1, BM2 ... BMn) est configuré de telle sorte qu'il serre l'une contre l'autre la surface de refroidissement de composant (BEK1, BEK2 ... BEKn) du composant électronique (BE1, BE2 ... BEn) et la surface de refroidissement de dissipateur thermique (KF1, KF2).

7. Dispositif (100) selon l'une quelconque des revendications 1 à 3, **caractérisé en ce qu'**un moyen de fixation (BM1, BM2 ... BMn) comprend une vis ou un rivet.

8. Module de puissance (LM) permettant de piloter un entraînement électrique (EM), comprenant un dispositif (100) selon l'une quelconque des revendications précédentes pour refroidir la pluralité installée des composants électriques (BE1, BE2 ... BEn), en particulier des éléments de commutation (SE) et/ou des commutateurs semi-conducteurs de puissance.

9. Onduleur (WR) comprenant un module de puissance (LM) selon la revendication 8.
